# EUROPEAN PATENT APPLICATION

(11) **EP 1 357 596 A2**
(43) Date of publication of application: **29.10.2003**
(21) Application number: 03008935.3
(22) Date of filing: 16.04.2003
(51) Int. Cl.: H01L 23/498, H01L 23/13

(54) **Semiconductor device and method of fabricating the same**

(30) Priority: 22.04.2002 JP 2002118706
(71) Applicant: NEC Compound Semiconductor Devices, Ltd., Kawasaki-shi, Kanagawa (JP)
(72) Inventor: Nakazawa, Taibo, NEC Compound Semiconductor Devic., Kawasaki-shi, Kanagawa (JP); Hirasawa, Koki, NEC Compound Semiconductor Devices, Kawasaki-shi, Kanagawa (JP)
(74) Representative: Glawe. Delfs. Moll

(57) **Abstract**

An electronic device (10) includes (a) a first wiring substrate (11) including a metal area (111) and formed with a recess (15) reaching the metal area (111), and (b) a second wiring substrate (12) including a ground electrode formed in an area other than a signal transmission path at the recess (15) and around the recess (15) when coupled to the first wiring substrate (11), and further including at least one first electronic part (14) mounted thereon. The first and second wiring substrates (11, 12) are coupled directly to each other such that the first electronic part (14) is located in the recess (15).

## Description

### BACKGROUND OF THE INVENTION

### FIELD OF THE INVENTION

The invention relates to an electronic device including an electronic part and a method of fabricating the same, and more particularly to a semiconductor device and a method of fabricating the same.

### DESCRIPTION OF THE RELATED ART

There have been suggested a lot of chips which include a plurality of pins and operate at a clock frequency of 100 MHz or greater, in response to a recent requirement of higher integration and higher operation speed of LSI. In a device including such a chip as operating at a high rate, a signal transmitted through a package and a printed board much delays, and a parasitic capacitance and inductance of a package are not ignorable. Such signal delay and parasitic capacitance prevent an overall system including the device from operating at a high rate.

In order to solve such problems, there has been suggested a multi-chip module (MCM). A multi-chip module is comprised of a plurality of chips arranged as close as possible to one another, and can reduce signal delay among chips, and ensure high rate operation in each of chips.

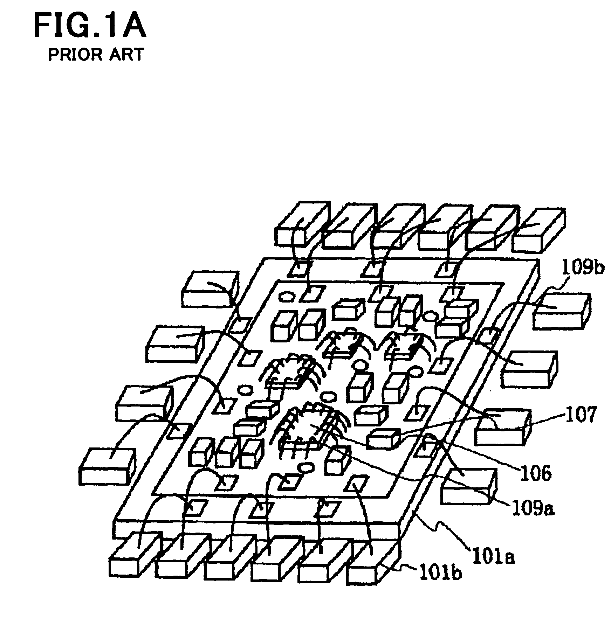

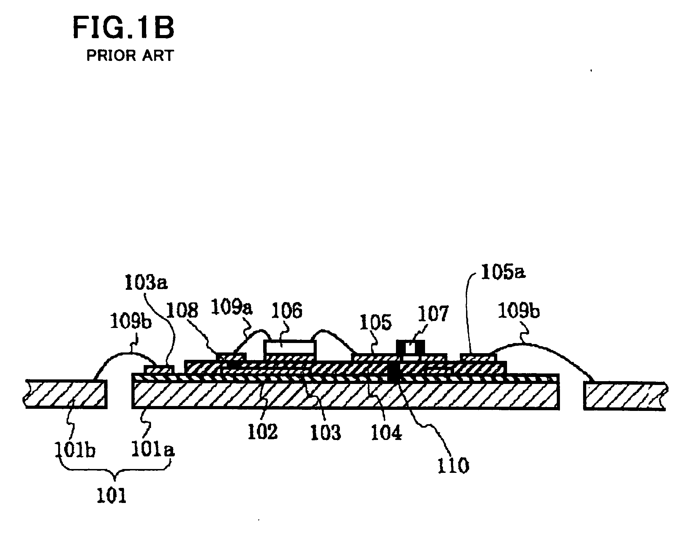

An example of a multi-chip module is suggested in Japanese Patent No. 3171172 (Japanese Patent Application Publication No. 2000-101015). FIG. 1A is a perspective view of a multi-chip module suggested in the Japanese Patent, and FIG. 1B is a cross-sectional view of the multi-chip module illustrated in FIG. 1A.

On an island 101a of a lead frame 101 comprised of a metal plate is formed a first wiring layer 103 with an electrically insulating lower layer 102 being sandwiched therebetween. A second wiring layer 105 is formed partially on the first wiring layer 103 with an interlayer insulating layer 104 being sandwiched therebetween. On the second wiring layer 105 are mounted IC chips 106, resistors, and single chips 107 such as a capacitor.

The first wiring layer 103 and the second wiring layer 105 are electrically connected to each other through a contact 108 formed in a contact hole formed throughout the interlayer insulating layer 104. Each of the IC chips 106 is electrically connected to electrodes formed on the second wiring layer 105, through a wire 109a. An electrode pad 103a of the first wiring layer 103 and an electrode pad 105a of the second wiring layer 105 are electrically connected to a lead 101b through wires 109b.

Each of the IC chips 106 is electrically connected to the island 101a through a contact 110 formed in a through-hole formed throughout the electrically insulating lower layer 102 and the interlayer insulating layer 104, and thus, grounded. Though not illustrated, the lead frame 101 on which the IC chips 106 and other parts are mounted is covered with molded resin.

FIG. 2 is a cross-sectional view of a multi-chip module suggested in Japanese Patent Application Publication No. 2001-274278, as another example of a multi-chip module.

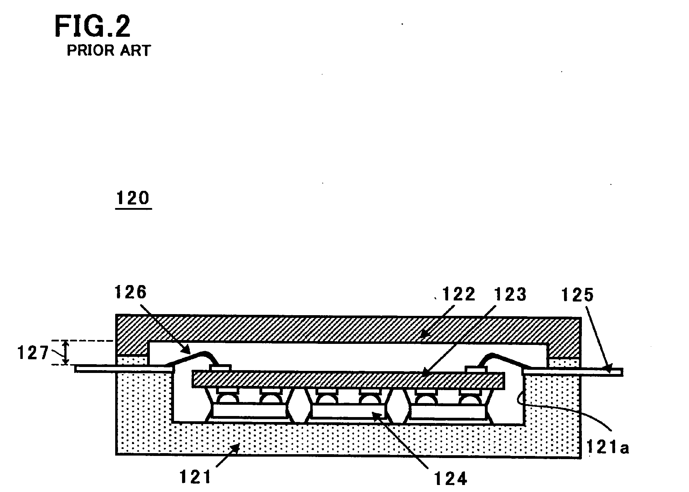

A multi-chip module 120 illustrated in FIG. 2 is comprised of a metal plate 121 formed at a surface thereof with a recess 121a, a ceramic cover 122 covering the recess 121a therewith, a dielectric substrate 123 accommodated in the recess 121a, a semiconductor chip 124 mounted on the dielectric substrate 123 in flip-chip junction, a package terminal 125 extending from inside of the recess 121a to outside of the metal plate 121, and bonding wires 126 for electrically connecting electrodes formed on the dielectric substrate 123 to the package terminals 125.

A multi-chip module as illustrated in FIGs. 1A, 1B and 2 is presently mounted in a variety of electronic devices. For instance, a cellular phone is designed to include such a multi-chip module.

A semiconductor circuit such as a multi-chip module irradiates electromagnetic waves while it is in operation. Accordingly, a device including a semiconductor circuit is usually designed to include a shield for shielding such electromagnetic waves. However, it is quite difficult to perfectly shield such electromagnetic waves. In fact, electromagnetic waves irradiating from a semiconductor circuit leaks out of a device to some degree.

As a result, there is caused a problem of how electromagnetic waves leaking out of a cellular phone influences a user.

In general, since it is not necessary for a cellular phone to receive much power for receiving radio signals, a radio-signal receiver in a cellular phone can be driven in small power. In contrast, a cellular phone consumes higher power in transmitting radio signals than in receiving radio signals. Accordingly, a radio signal transmitter in a cellular phone is driven in high power.

Hence, a radio signal transmitter in a cellular phone irradiates much electromagnetic waves therearound. As a result, devices in a radio-signal receiver sometimes wrongly operate due to leakage of electromagnetic waves out of a radio-signal transmitter, resulting in that it is quite difficult or almost impossible to fabricate a radio-signal transmitter and radio-signal receiver in a highly integrated multi-chip module.

In addition, as a result of irradiation of much electromagnetic waves, a radio-signal transmitter further irradiates heat therearound.

However, in the conventional multi-chip modules illustrated in FIGs. 1A and 1B, the IC chips 106 and the single chips 107 from which electromagnetic waves are irradiated are covered merely with molded resin. Since molded resin has no function of shielding electromagnetic waves, almost all of electromagnetic waves irradiated from the IC chips 106 and the single chips 107 are irradiated out of the multi-chip modules.

The IC chips 106 and the single chips 107 as heat source in the conventional multi-chip modules illustrated in FIGs. 1A and 1B are covered at lower surfaces thereof with the second wiring layer 105, the interlayer insulating layer 104, the first wiring layer 103 and the electrically insulating lower layer 102, and further covered at upper parts thereof with molded resin. Thus, heat generated in the IC chips 106 and the single chips 107 cannot be irradiated to outside of the multi-chip module. As a result, the conventional multi-chip module illustrated in FIGs. 1A and 1B has low heat irradiation property, and hence, is accompanied with problems caused by such low heat irradiation property.

The above-mentioned problems can be applied also to the multi-chip module illustrated in FIG. 2.

In the multi-chip module illustrated in FIG. 2, though the semiconductor chip 124 is covered at a lower part thereof with the metal plate 121, the semiconductor chip 124 is covered at an upper part thereof merely with the substrate 123 composed of ceramics. Accordingly, electromagnetic waves generated from the semiconductor chip 124 are upwardly irradiated without being shielded.

Since the semiconductor chip 124 is covered at a lower part thereof with the metal plate 121, heat generated in the semiconductor chip 124 is irradiated outside through the metal plate 121. Hence, the problem of low heat irradiation property in the conventional multi-chip module illustrated in FIGs. 1A and 1B is solved in the multi-chip module illustrated in FIG. 2.

However, the conventional multi-chip module illustrated in FIG. 2 is accompanied with another problem that a semiconductor device including the multi-chip module cannot avoid an increase in a size thereof. That is, since the dielectric substrate 123 and the package terminal 125 are electrically connected to each other through the bonding wires 126 in the conventional multi-chip module illustrated in FIG. 2, the multi-chip module has to be designed to have an additional space 127 for accommodating the bonding wires 126 therein. Accordingly, a semiconductor device including the multi-chip module cannot avoid having an additional height derived from the space 127.

### SUMMARY OF THE INVENTION

In view of the above-mentioned problems in the conventional semiconductor device, it is an object of the present invention to provide an electronic device which is capable of preventing irradiation of electromagnetic waves generated in the electronic device, and a method of fabricating the same.

Another object of the present invention is to provide an electronic device which is capable of sufficiently irradiating heat generated in the electronic device, and a method of fabricating the same.

In one aspect of the present invention, there is provided an electronic device (10, 20, 30, 40) including (a) a first wiring substrate including a metal area, and (b) a second wiring substrate on which at least one first electronic part is mounted, wherein the first and second wiring substrates are coupled to each other, characterized in that the first wiring substrate is formed with a recess reaching the metal area, the second wiring substrate includes a ground electrode formed in an area other than a signal transmission path at the recess and around the recess when coupled to the first wiring substrate, and the first and second wiring substrates are coupled directly to each other such that the first electronic part is located in the recess.

In another aspect of the present invention, there is provided a method of fabricating an electronic device, comprising the steps of (a) forming a recess at a surface of a first wiring substrate including a metal area such that the recess reaches the metal area, (b) mounting a first electronic part on a surface of a second wiring substrate including a ground electrode formed in an area other than a signal transmission path at the recess and around the recess when coupled to the first wiring substrate, and (c) adhering the first and second wiring substrates directly to each other such that the first electronic part is located in the recess.

The advantages obtained by the aforementioned present invention will be described hereinbelow.

The first advantage is that it is possible to shield electromagnetic waves irradiated from an electronic part.

Since an electronic part is surrounded by the first wiring substrate including the metal area and the second wiring substrate including a ground electrode formed in an area other than a signal transmission path, it would be possible to almost perfectly shield electromagnetic waves irradiated from an electronic part.

The second advantage is that a semiconductor device can be fabricated in a smaller size.

In the electronic device in accordance with the present invention, an electronic part is accommodated in the first wiring substrate, and hence, an electronic part can be three-dimensionally mounted. In addition, since a wiring area of the first wiring substrate and a wiring area of the second wiring substrate are coupled directly to each other, it would be possible to lower a height of the electronic device, and hence, a height of a semiconductor circuit including the electronic device.

The third advantage is that it is possible to enhance heat radiation property of an electronic device.

By arranging an electronic part in the recess such that a bottom of the electronic part makes direct contact with a bottom of the recess, heat generated in the electronic part is transferred directly to the first wiring substrate, and thereafter, irradiated to atmosphere or a substrate of the electronic device. Accordingly, it would be possible to prevent a temperature of an electronic part from rising, ensuring enhancement in high-frequency characteristics and reliability of the electronic device in accordance with the present invention.

The fourth advantage is that it is possible to test an electronic part to be mounted in the electronic device prior to completion of the electronic device.

As a result, since defective intermediate products can be removed, it would be possible to shorten a fabrication time and reduce manpower for fabricating the electronic device in comparison with a case where defective final products are removed.

The fifth advantage is that it would be possible to shorten a signal transmission path.

In the electronic device in accordance with the present invention, it is possible to directly couple the first and second wiring substrates to each other, and mount an electronic part on the second wiring substrate in flip-chip junction. Hence, it is possible to shorten a wiring length in comparison with a case where an electronic part is electrically connected to the second wiring substrate through a bonding wire, ensuring suppression of signal delay and electromagnetic noises both of which are caused in proportion to a wiring length.

The sixth advantage is that it is possible to mount electronic parts at a high density.

As mentioned above, the present invention makes it possible to electromagnetically shield an electronic part from surroundings. Hence, a plurality of electronic parts can be mounted on the electronic device in accordance with the present invention, ensuring arrangement of electronic parts at a high density.

In addition, since an electronic part is electromagnetically shielded from surroundings, it would be possible to mount other electronic parts on the second wiring substrate, which ensures arrangement of electronic parts at a higher density.

### BRIEF DESCRIPTION OF THE DRAWINGS

FIG. 1A is a perspective view of a conventional multi-chip module.
FIG. 1B is a cross-sectional view of the multi-chip module illustrated in FIG. 1A.
FIG. 2 is a cross-sectional view of another conventional multi-chip module.
FIG. 3 is a cross-sectional view of the electronic device in accordance with the first embodiment of the present invention.
FIGs. 4A to 4E are cross-sectional views of the electronic device in accordance with the first embodiment, illustrating respective steps of a method of fabricating the same.
FIG. 5 is a cross-sectional view of the electronic device in accordance with the second embodiment of the present invention.
FIG. 6 is a cross-sectional view of the electronic device in accordance with the third embodiment of the present invention.
FIG. 7 is a cross-sectional view of a variant of the electronic device in accordance with the third embodiment of the present invention.
FIG. 8 is a cross-sectional view of the electronic device in accordance with the fourth embodiment of the present invention.

### DESCRIPTION OF THE PREFERRED EMBODIMENTS

### [First Embodiment]

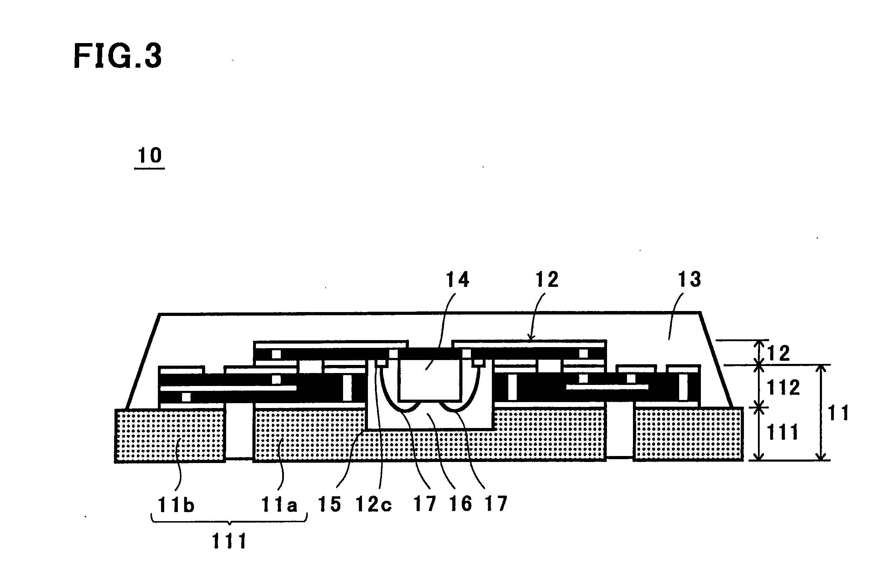

FIG. 3 is a cross-sectional view of an electronic device 10 in accordance with the first embodiment of the present invention.

The electronic device 10 is comprised of a lead frame 11 as a first wiring substrate, a cover-type wiring substrate 12 as a second wiring substrate which is coupled to the lead frame 11, and molded resin 13 covering the lead frame 11 and the cover-type wiring substrate 12 therewith.

The lead frame 11 as a first wiring substrate is comprised of a metal plate 111 defining an island 111a and a lead 111b, and a circuit board 112 formed on the metal plate 111.

The metal plate 111 is composed of metal such as copper or copper alloy. The island 111a is formed at a surface thereof with a recess 15 having a shape matching to a shape of a later mentioned high-frequency integrated circuit (IC) 14. The recess 15 may be formed, for instance, by half-etching the island 111a and the circuit board 112.

The cover-type wiring substrate 12 is formed with a ground electrode in a region other than signal transmission paths in an area which the recess 15 and therearound thereof will occupy when the cover-type wiring substrate 12 is coupled to the lead frame 11.

A high-frequency IC 14 as an electronic part is mounted on a lower surface of the cover-type wiring substrate 12. The high-frequency IC 14 is electrically connected to an electrode 12c formed on a lower surface of the cover-type wiring substrate 12, through a bonding wire 17.

The lead frame 11 and the cover-type wiring substrate 12 are coupled to each other such that the high-frequency IC 14 is accommodated in the recess 15.

For instance, the lead frame 11 and the cover-type wiring substrate 12 may be coupled to each other by coating electrically conductive paste or solder onto an area at which the lead frame 11 and the cover-type wiring substrate 12 are coupled to each other, and heating the paste or solder.

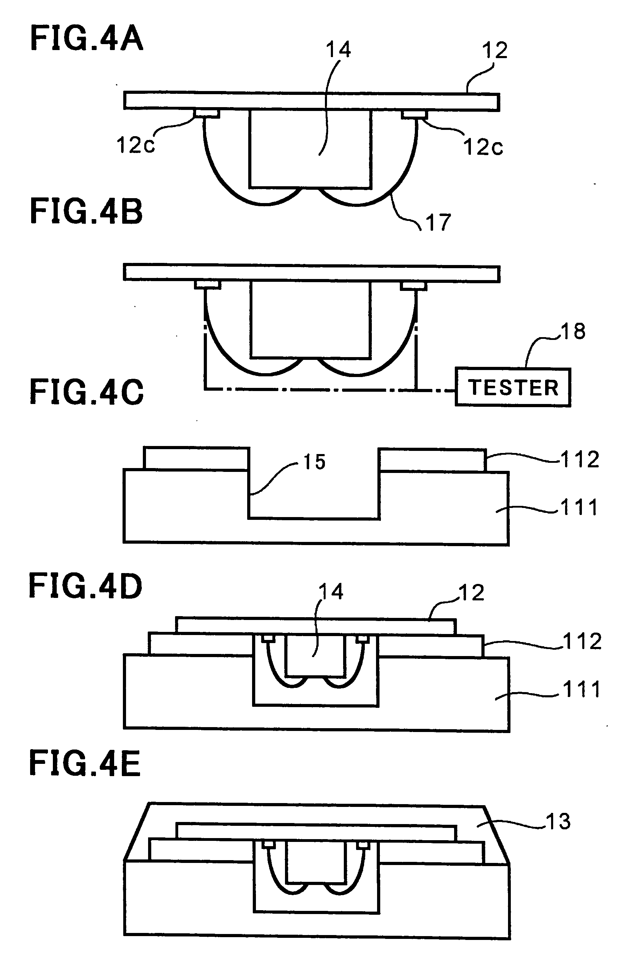

FIGs. 4A to 4E are cross-sectional views of the electronic device 10, illustrating respective steps of a method of fabricating the electronic device 10. Hereinbelow is explained a method of fabricating the electronic device 10, with reference to FIGs. 4A to 4E.

First, as illustrated in FIG. 4A, the high-frequency IC 14 is mounted on a lower surface of the cover-type wiring substrate 12.

Then, the high-frequency IC 14 is electrically connected to the electrode 12c through the bonding wire 17.

Then, as illustrated in FIG. 4B, an operation test is carried out at this stage to the high-frequency IC 14 by means of a tester 18. An operation test is carried out by electrically connecting the tester 18 to the electrode 12c. In accordance with the results of the operation test, defective high-frequency ICs 14 are removed, and only non-defective high-frequency ICs 14 are selected.

Then, as illustrated in FIG. 4C, the recess is formed at a surface of the lead frame 111.

A depth of the recess 15 is determined in accordance with a height of the high-frequency IC 14.

Then, as illustrated in FIG. 4D, the lead frame 11 and the cover-type wiring substrate 12 are coupled to each other such that the high-frequency IC 14 is accommodated in the recess 15.

Then, as illustrated in FIG. 4E, the cover-type wiring substrate 12 is covered with the molded resin 13.

By carrying out the above-mentioned steps, there is completed the electronic device 10 illustrated in FIG. 3.

The electronic device 10 in accordance with the first embodiment provides the following advantages.

The first advantage is that the electronic device 10 can shield electromagnetic waves irradiated from the high-frequency IC 14.

Since the high-frequency IC 14 is surrounded by the metal plate 111 and the cover-type wiring substrate 12 including a ground electrode formed in an area other than signal transmission paths around the recess 15, it would be possible to almost perfectly shield electromagnetic waves irradiated from the high-frequency IC 14, and resultingly, electromagnetic waves do not leak out of the electronic device 10.

As a result, it is possible to prevent generation of electromagnetic noises derived from the high-frequency IC 14. In addition, when other semiconductor chips are arranged around the high-frequency IC 14, it would be possible to prevent malfunction of the semiconductor chips caused by electromagnetic waves generated from the high-frequency IC 14. Furthermore, it is no longer necessary to use a metal cap for shielding electromagnetic waves generated from the high-frequency IC 14.

The second advantage is that a semiconductor device including the electronic device 10 can be fabricated in a smaller size.

In the electronic device 10 in accordance with the first embodiment, the high-frequency IC 14 as an electronic part is accommodated in the lead frame 11, and hence, the high-frequency IC 14 can be three-dimensionally mounted. In addition, since a wiring area of the circuit board 111 and a wiring area of the cover-type wiring substrate 12 are coupled directly to each other, it would be possible to lower a height of the electronic device 10, and hence, a height of a semiconductor circuit including the electronic device 10.

The third advantage is that it is possible to test the high-frequency IC 14 to be mounted in the electronic device 10 prior to the completion of the electronic device 10.

In the conventional electronic device illustrated in FIGs. 1A and 1B, it was possible to test a semiconductor chip only after the completion of the electronic device. Hence, if a semiconductor chip was found defective in the test, the electronic device including such a defective semiconductor chip has to be abandoned. As a result, parts constituting the electronic device to be abandoned, and time and manpower necessary for fabricating the electronic device are all in vain.

In contrast, since the electronic device 10 in accordance with the first embodiment is designed to be comprised separately of the lead frame 11 and the cover-type wiring substrate 12, it is possible to test the high-frequency IC 14 if the high-frequency IC 14 is once mounted on the cover-type wiring substrate 12. Accordingly, it would be possible to remove defective high-frequency ICs 14 at this stage.

As mentioned above, the electronic device 10 in accordance with the first embodiment makes it possible to distinguish non-defective and defective semiconductor chips from each other at a stage of an intermediate product, that is, at a stage of the fabrication of the cover-type wiring substrate 12. Hence, if a semiconductor chip is found defective, only the cover-type wiring substrate 12 as an intermediate product including the defective semiconductor chip is abandoned, and hence, it is no longer necessary to abandon a final product or a semiconductor device.

The fourth advantage is that it is possible to shorten a signal transmission path.

In a conventional multi-chip module, first and second substrates are electrically connected to each other generally through a bonding wire, as shown in Japanese Patent Application Publication N. 2001-274278. In contrast, in the electronic device 10 in accordance with the first embodiment, it is possible to directly couple the lead frame 11 and the cover-type wiring substrate 12 as first and second wiring substrates to each other through electrically conductive paste or solder. Hence, it is no longer necessary to use a bonding wire, and resultingly, it is possible to shorten a signal transmission path.

### [Second Embodiment]

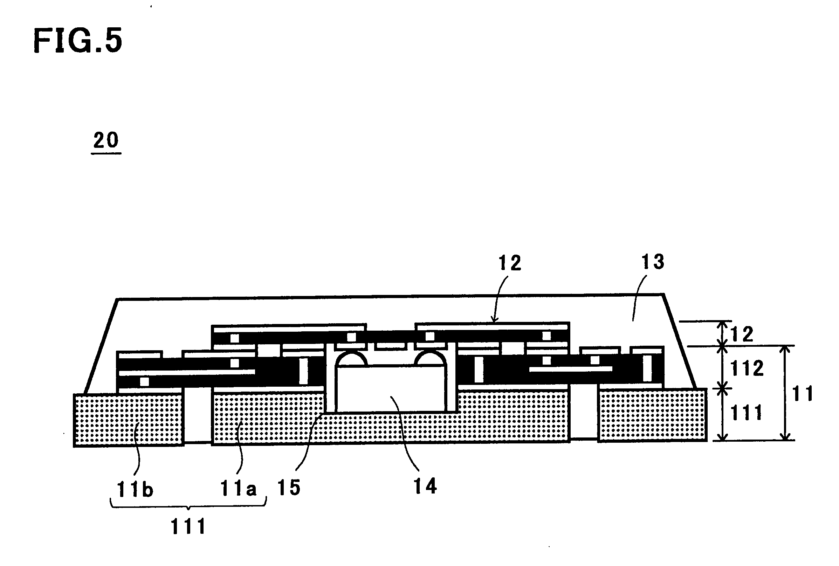

FIG. 5 is a cross-sectional view of an electronic device 20 in accordance with the second embodiment.

In the electronic device 10 in accordance with the first embodiment, the high-frequency IC 14 is electrically connected to the electrode 12c through the bonding wire 17. In contrast, the high-frequency IC 14 in the second embodiment is electrically connected to the cover-type wiring substrate 12 in flip-chip junction.

The electronic device 20 in accordance with the second embodiment has the same structure of the structure of the electronic device 10 in accordance with the first embodiment except that the high-frequency IC 14 is electrically connected to the cover-type wiring substrate 12 in flip-chip junction.

In the electronic device 20, the high-frequency IC 14 is electrically connected at an upper surface thereof to the cover-type wiring substrate 12 in flip-chip. As a result, as illustrated in FIG. 5, the high-frequency IC 14 can be arranged in the recess 15 such that a bottom of the high-frequency IC 14 makes contact with a bottom of the recess 15.

The high-frequency IC 14 may be fixed at a bottom thereof onto a bottom of the recess 15 through solder or electrically conductive paste. Herein, solder may be comprised of SnPd, SnAgCu or AuSn.

Not only the high-frequency IC 14 and the lead frame 11, but also the cover-type wiring substrate 12 and the lead frame 11 can be adhered to each other by coating electrically conductive paste or solder onto a certain area of the recess 15 and the cover-type wiring substrate 12, and heating the paste or solder.

For this end, the recess 15 is designed to have such a depth that a bottom of the high-frequency IC 14 makes contact with a bottom of the recess 15 through the above-mentioned paste or solder.

The electronic device 20 in accordance with the second embodiment can be fabricated in accordance with the same method as the method of fabricating the electronic device 10 in accordance with the second embodiment. The high-frequency IC 14 is electrically connected to the cover-type wiring substrate 12 in flip-flop junction in place of through the bonding wire 17.

The electronic device 20 in accordance with the second embodiment provides the following advantages.

The first advantage is that the electronic device 20 makes it possible to shield electromagnetic waves irradiated from the high-frequency IC 14, similarly to the electronic device 10 in accordance with the first embodiment.

The second advantage is that it is possible to fabricate a semiconductor device including the electronic device 20, in a smaller size, similarly to the electronic device 10 in accordance with the first embodiment.

The third advantage is that an operation test can be carried out to the high-frequency IC 14 prior to the completion of the electronic device 20, similarly to the electronic device 10 in accordance with the first embodiment.

The fourth advantage is that a signal transmission path can be made smaller than the same in the first embodiment.

Similarly to the first embodiment, a wiring length can be shortened by directly coupling the lead frame 11 and the cover-type wiring substrate 12 to each other.

In the electronic device 10 in accordance with the first embodiment, illustrated in FIG. 3, the high-frequency IC 14 is electrically connected to the cover-type wiring substrate 12 through the bonding wire 17. In contrast, the high-frequency IC 14 is coupled to the cover-type wiring substrate 12 in flip-chip junction in the electronic device 20 in accordance with the second embodiment. Hence, it is possible to further shorten a wiring length in comparison with the electronic device 10 in accordance with the first embodiment, and suppress signal delay and electromagnetic noises both of which are generated in proportion to a wiring length.

The fifth advantage is that it is possible to enhance heat radiation property of the electronic device 20.

In the electronic device 20 in accordance with the second embodiment, a bottom of the high-frequency IC 14 makes direct contact with a bottom of the recess 15. Hence, heat generated in the high-frequency IC 14 is transferred directly to the lead frame 11, and thereafter, irradiated to atmosphere or a substrate (not illustrated) of the electronic device 20. Accordingly, it would be possible to prevent a temperature of the high-frequency IC 14 from rising, ensuring enhancement in high-frequency characteristics and reliability of the electronic device 20 in accordance with the second embodiment.

The electronic device 20 is designed to include the high-frequency IC 14 which generates heat during operation thereof. Hence, in the second embodiment, heat is irradiated by arranging the high-frequency IC 14 in the recess 15 such that a bottom of the high-frequency IC 14 makes contact with a bottom of the recess 15 for directly transferring the heat to the lead frame 11. When an electronic device which does not generate heat during operation thereof, for instance, a surface acoustic wave (SAW) filter is used in place of the high-frequency IC 14, it is not necessary to form a path through which heat escapes to outside of the electronic device 20, and hence, it is not always necessary to arrange a surface acoustic wave filter in the recess 15 such that a bottom of the filter makes contact with a bottom of the recess 15.

### [Third Embodiment]

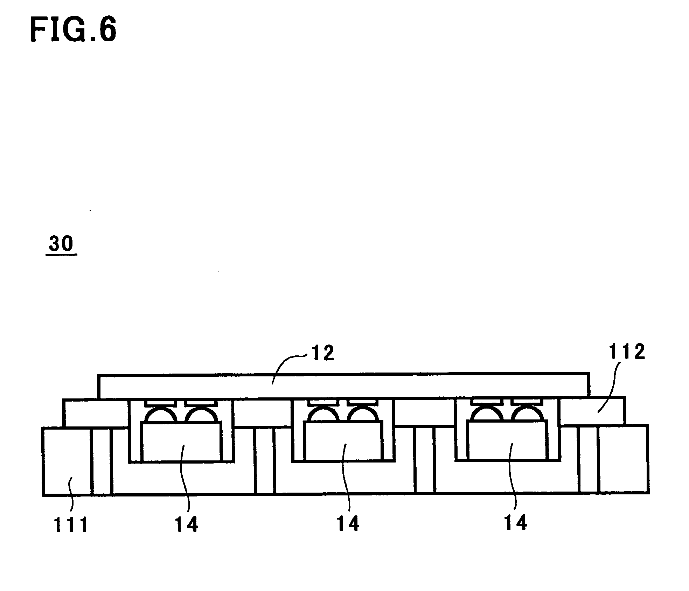

FIG. 6 is a cross-sectional view of an electronic device 30 in accordance with the third embodiment.

In the electronic device 30 in accordance with the third embodiment, three high-frequency ICs 14 are mounted on the cover-type wiring substrate 12, and the lead frame 11 is formed at a surface thereof with three recesses 15 at the same pitch as a pitch at which the three high-frequency ICs 14 are arranged. Each of the recesses 15 is associated with each of the high-frequency ICs 14.

The electronic device 30 in accordance with the third embodiment has the same structure of the structure of the electronic device 20 in accordance with the second embodiment except that the electronic device 30 includes three high-frequency ICs 14 and three recesses 15.

The electronic device 30 in accordance with the third embodiment can be fabricated in accordance with the same method as a method of fabricating the electronic device 20 in accordance with the second embodiment except that the method of fabricating the electronic device 30 has the steps of concurrently coupling the three high-frequency ICs 14 to the cover-type wiring substrate 12 in flip-chip junction, and concurrently forming the three recesses 15 at a surface of the lead frame 11.

A ground electrode formed on the cover-type wiring substrate 12 has such a pattern that the high-frequency ICs 14 are not short-circuited with one another.

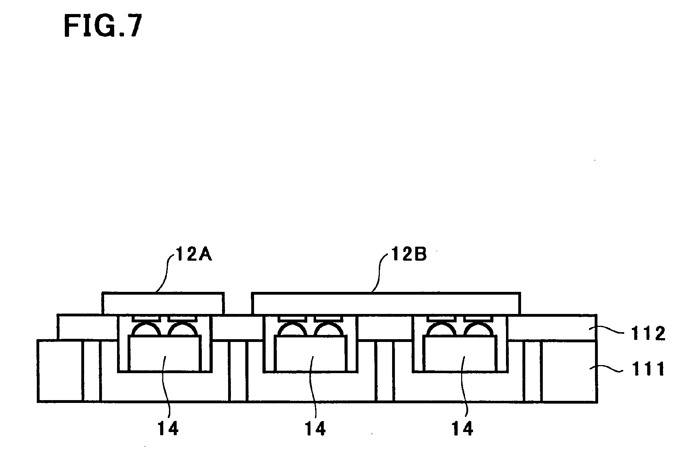

FIG. 7 is a cross-sectional view of a variant of the electronic device 30 in accordance with the third embodiment.

In the variant, the cover-type wiring substrate 12 is comprised of first and second sub-substrates 12A and 12B. One high-frequency IC 14 is mounted on the first sub-substrate 12A, and two high-frequency ICs 14 are mounted on the second sub-substrate 12B.

The cover-type wiring substrate 12 may be comprised of a single substrate, as shown in FIG. 5 or 6, or a plurality of sub-substrates on each of which any number of high-frequency ICs 14 may be mounted, as shown in FIG. 7, in which case, the lead frame 11 is formed with the recesses 15 in association with the high-frequency ICs 14.

Though the electronic device 30 and the variant are designed to include three high-frequency ICs 14 and three recesses 15, the number of the high-frequency ICs 14 and the recesses 15 is not to be limited to three, but may be two or more.

The electronic device 30 in accordance with the third embodiment provides the same advantages as those provided by the electronic device 20 in accordance with the second embodiment.

In addition, the electronic device 30 in accordance with the third embodiment provides the sixth advantage that high-frequency ICs 14 can be arranged at a high density.

In the electronic device 30, each of the high-frequency ICs 14 is electromagnetically shielded from the rest of the high-frequency ICs 14 by means of both the lead frame 11 and the cover-type wiring substrate 12 including a ground electrode formed in a region other than signal transmission paths, ensuring that a plurality of high-frequency ICs 14 can be arranged at a high density.

### [Fourth Embodiment]

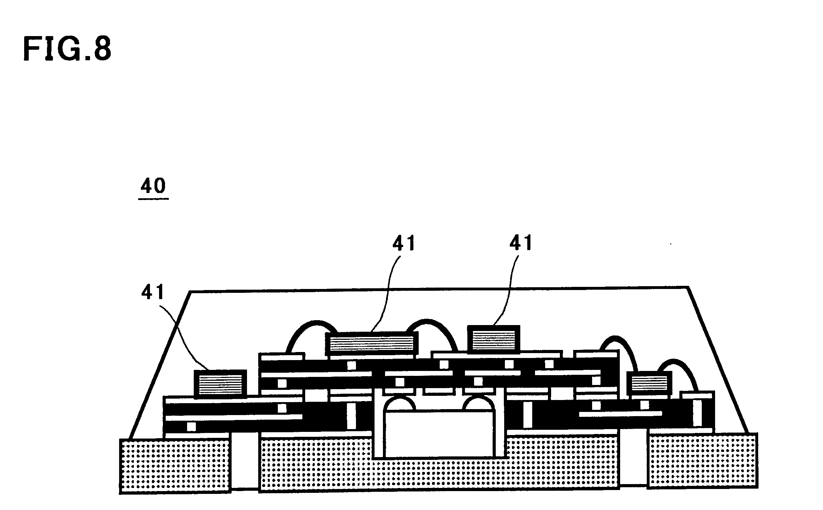

FIG. 8 is a cross-sectional view of an electronic device 40 in accordance with the fourth embodiment.

The electronic device 40 in accordance with the fourth embodiment is designed to include a plurality of ICs 41 mounted on the cover-type wiring substrate 12, apart from the high-frequency IC 14. Except that, the electronic device 40 in accordance with the fourth embodiment has the same structure of the structure of the electronic device 20 in accordance with the second embodiment.

The electronic device 40 in accordance with the fourth embodiment can be fabricated in accordance with the same method as a method of fabricating the electronic device 20 in accordance with the second embodiment except that the method of fabricating the electronic device 40 additionally has the step of mounting the ICs 41 on the cover-type wiring substrate 12 after the lead frame 11 and the cover-type wiring substrate 12 have been coupled to each other, but before the cover-type wiring substrate 12 is covered with the molded resin 13.

The electronic device 40 in accordance with the fourth embodiment provides the same advantages as those provided by the electronic device 20 in accordance with the second embodiment, and further provides the sixth advantage that the ICs 41 other than the high-frequency IC 14 can be mounted on the cover-type wiring substrate 12.

In the electronic device 40 in accordance with the fourth embodiment, the high-frequency IC 14 is electromagnetically shielded from the other ICs 41 by the cover-type wiring substrate 12 including a ground electrode formed in an area other than signal transmission paths. Hence, it is possible to arrange a plurality of ICs 41 in the vicinity of the high-frequency IC 14, and resultingly, the high-frequency IC 14 and the other ICs 41 can be arranged at a high density.

The ICs 41 illustrated in FIG. 8 may be mounted on the cover-type wiring substrate 12 not only in the electronic device 20 illustrated in FIG. 5, but also in the electronic device 10 illustrated in FIG. 3, the electronic device 30 illustrated in FIG. 6 or the variant of the electronic device 30 illustrated in FIG. 7.

The high-frequency IC 14 is accommodated in the recess 15 in the above-mentioned first to fourth embodiments, but another electronic part may be accommodated in the recess 15 in place of the high-frequency IC 14. Specifically, any electronic part may be selected in place of the high-frequency IC 14, if it irradiates electromagnetic waves during operation thereof, or it is required to have enhanced heat radiation property.

In the above-mentioned first to fourth embodiments, the cover-type wiring substrate 12 and the circuit board 111 may be designed to have a multi-layered structure.

In the above-mentioned first to fourth embodiments, the lead frame 11 as the first wiring substrate is comprised of the metal plate 111 and the circuit board 112. It should be noted that the lead frame 11 may be comprised only of the metal plate 111.

## Claims

1. An electronic device (10, 20, 30, 40) including:
(a) a first wiring substrate (11) including a metal area (111); and
(b) a second wiring substrate (12) on which at least one first electronic part (14) is mounted,
wherein the first and second wiring substrates (11, 12) are coupled to each other,
**characterized in that**
the first wiring substrate (11) is formed with a recess (15) reaching the metal area (111),
the second wiring substrate (12) includes a ground electrode formed in an area other than a signal transmission path at the recess (15) and around the recess (15) when coupled to the first wiring substrate (11), and
the first and second wiring substrates (11, 12) are coupled directly to each other such that the first electronic part (14) is located in the recess (15).

2. The electronic device as set forth in claim 1, wherein the first wiring substrate (11) is formed with a plurality of recesses (15) each reaching the metal area (111), a plurality of the first electronic parts (14) is mounted on the second wiring substrate (12) comprised of at least one sub-substrate (12A, 12B) including a ground electrode formed in an area other than a signal transmission path at the recess (15) and around the recess (15) when coupled to the first wiring substrate (11), and further including a plurality of first electronic parts (14) mounted thereon, and the first and second wiring substrates (11, 12) are coupled directly to each other such that each of the first electronic parts (14) is located in the associated recess (15).

3. The electronic device (10, 20, 30, 40) as set forth in claim 1 or 2, wherein the first wiring substrate (11) is comprised of the metal area (111) and a circuit board (112).

4. The electronic device (10, 20, 30, 40) as set forth in claim 1 or 2, wherein the first electronic part (14) is electrically connected to the second wiring substrate (12) through a bonding wire (17).

5. The electronic device (10, 20, 30, 40) as set forth in claim 1 or 2, wherein the first electronic part (14) is electrically connected to the second wiring substrate (12) in flip-chip junction.

6. The electronic device (10, 20, 30, 40) as set forth in claim 1 or 2, wherein the recess (15) has such a depth that a bottom of the first electronic part (14) makes direct contact with a bottom of the recess (15) or a bottom of the first electronic part (14) make contact with a bottom of the recess (15) through an electrically conductive adhesive layer.

7. The electronic device (10, 20, 30, 40) as set forth in claim 1 or 2, wherein at least one of the first and second wiring substrates (11, 12) is comprised of a plurality of wiring layers.

8. The electronic device (10, 20, 30, 40) as set forth in claim 1 or 2, wherein the first electronic part (14) is a semiconductor device.

9. The electronic device (10, 20, 30, 40) as set forth in claim 1 or 2, further comprising at least one second electronic part (41) mounted on a surface of the second wiring substrate (12) which surface is opposite to a surface on which the first electronic part (14) is mounted.

10. A method of fabricating an electronic device (10, 20, 30, 40), comprising the steps of
(a) forming a recess (15) at a surface of a first wiring substrate (11) including a metal area (111) such that the recess (15) reaches the metal area (111);
(b) mounting a first electronic part (14) on a surface of a second wiring substrate (12) including a ground electrode formed in an area other than a signal transmission path at the recess (15) and around the recess (15) when coupled to the first wiring substrate (11); and
(c) coupling the first and second wiring substrates (11, 12) directly to each other such that the first electronic part (14) is located in the recess (15).

11. The method as set forth in claim 10, wherein a plurality of recesses (15) is formed at a surface of the first wiring substrate (11) in the step (a), a plurality of the first electronic parts (14) is mounted on the second wiring substrate (12) comprised of a plurality of sub-substrates (12A, 12B) including a ground electrode formed in an area other than a signal transmission path at the recess (15) and around the recess (15) when coupled to the first wiring substrate (11), and the first and second wiring substrates (11, 12) are coupled directly to each other such that each of the first electronic parts (14) is located in the associated recess (15).

12. The method as set forth in claim 10 or 11, further comprising the step of (d) testing the first electronic part (14) with respect to an operation thereof, the step (d) being carried out prior to the step (c).

13. The method as set forth in claim 10 or 11, further comprising the step of electrically connecting the first electronic part (14) to the second wiring substrate (12) through a bonding wire (17).

14. The method as set forth in claim 10 or 11, further comprising the step of electrically connecting the first electronic part (14) to the second wiring substrate (12) in flip-chip junction.

15. The method as set forth in claim 14, wherein a bottom of the first electronic part (14) is adhered to a bottom of the recess (15) through an electrically conductive adhesive layer in the step (c).

16. The method as set forth in claim 10 or 11, further comprising the step of mounting at least one second electronic part (41) on a surface of the second wiring substrate (12) which surface is opposite to a surface on which the first electronic part (14) is mounted.
